# EUROPÄISCHE PATENTSCHRIFT

(11) **EP 1 876 879 B1**
(45) Veröffentlichungstag und Bekanntmachung des Hinweises auf die Patenterteilung: **12.05.2010**
(21) Anmeldenummer: 07109211.8
(22) Anmeldetag: 30.05.2007
(51) Int. Cl.: H05K 13/04, H05K 13/08

(54) **Klassifizierung von aufgenommenen Bauelementen bei der Bestückung von Bauelementeträgern**
Classification of components when equipping component supports
Classification de composants amovibles pour le garnissage de supports de composants

(30) Priorität: 30.06.2006 DE 102006030292
(43) Veröffentlichungstag der Anmeldung: 09.01.2008
(73) Patentinhaber: Siemens Electronics Assembly Systems GmbH & Co. KG, 81379 München (DE)
(72) Erfinder: Neumaier, Klaus, 81369, München (DE)

(56) Entgegenhaltungen:
- EP-A- 0 891 129
- EP-A- 1 175 137
- EP-A- 1 189 497
- EP-A- 1 622 442
- US-A1- 2004 168 310

## Beschreibung

Die Erfindung betrifft die Bestückung von Bauelementeträgern mit Bauelementen mittels so genannter Bestückautomaten. Die Erfindung betrifft insbesondere ein Verfahren zum Klassifizieren eines von einer Haltevorrichtung aufgenommenen elektronischen Bauelements zum Zwecke einer fehlerfreien Bestückung eines Bauelementeträgers mit dem Bauelement.

Die vorliegende Erfindung betrifft ferner einen Bestückautomat, welcher zur Durchführung des erfindungsgemäßen Verfahrens zum Klassifizieren eines aufgenommenen elektronischen Bauelements eingerichtet ist.

Außerdem betrifft die Erfindung ein computerlesbares Speichermedium sowie ein Programm-Element, welche Instruktionen zur Durchführung des erfindungsgemäßen Verfahrens zum Klassifizieren eines aufgenommenen Bauelements enthalten.

Bei der automatischen Bestückung von Bauelementeträgern in so genannten Bestückautomaten werden Bauelemente von einer Bauelement-Zuführeinrichtung an bestimmten Abholpositionen bereitgestellt und von einem Bestückkopf abgeholt, welcher mittels eines Positioniersystems innerhalb eines Arbeitsbereiches frei positioniert werden kann. Die abgeholten Bauelemente werden von dem Bestückkopf zu einer Bestückposition transportiert und auf dem zu bestückenden Bauelementeträger an durch entsprechende Anschlussflächen definierte Einbaupositionen aufgesetzt.

Aufgrund der zunehmenden Miniaturisierung von elektronischen Bauelementen ist ein präziser Bestückvorgang nur durch eine genaue optische Lagevermessung der von dem Bestückkopf aufgenommenen Bauelemente möglich. Ebenso ist eine präzise Lagevermessung des zu bestückenden Bauelementeträgers erforderlich, damit von dem Bestückkopf die Bestückpositionen präzise angefahren werden können. Die Lagevermessung von Bauelementeträgern erfolgt üblicherweise anhand spezieller an den jeweiligen Bauelementeträgern angebrachten Markierungen.

Die Miniaturisierung betrifft jedoch nicht nur die Größe der elektronischen Bauelemente. Um ganze elektronische Baugruppen möglichst kompakt aufzubauen, werden auch die Abstände zwischen den Bauelement-Einbaupositionen auf einem Bauelementeträger bzw. auf einer Leiterplatte immer kleiner gewählt. So werden beispielsweise Bauelemente mit der sog. Gehäuseform 01005, die eine Auflagefläche von 0,4 mm x 0,2 mm aufweisen, mit Abständen von typischerweise 100µm auf einen Bauelementeträger platziert. Der Abstand wird dabei zwischen den einander gegenüberliegenden Kanten zweier nebeneinander auf einem Bauelementeträger angeordneten Bauelemente gemessen.

Der in der Praxis minimal realisierbare Abstand der Bauelemente auf dem Bauelementeträger wird dabei neben der Bestückgenauigkeit des Bestückautomaten auch durch die Abholgenauigkeit bestimmt. Unter dem Begriff Abholgenauigkeit ist in diesem Zusammenhang die räumliche Genauigkeit zu verstehen, mit der ein Bauelement von einer Bauelement-Haltevorrichtung aufgenommen wird. Wenn ein kleines Bauelement von der Haltevorrichtung nicht mittig sondern mit einem lateralen Versatz aufgenommen wird, dann besteht beim Aufsetzen des Bauelements auf den Bauelementeträger die Gefahr, dass ein seitlich überstehender Teil der Spitze der Haltevorrichtung ein bereits bestücktes Nachbarbauelement berührt. Dabei kann das Nachbarbauelement beschädigt und/oder aus seiner vorgegebenen Einbauposition verschoben werden, so dass im Ergebnis eine fehlerhafte Bestückung des Bauelementeträgers vorliegt.

Um eine derartige fehlerhafte Bestückung zu vermeiden, muss der Versatz der aufgenommenen Bauelemente zu der Haltevorrichtung beispielsweise durch ein Vision System geprüft und, falls ein erlaubter Versatz überschritten ist, das Bauelement verworfen werden.

Bei bekannten Bestückautomaten wird der Versatz eines aufgenommenen Bauelements dadurch bestimmt, dass die entsprechende Haltevorrichtung im Gesichtsfeld eines Vision Systems um ihre Längsachse gedreht und dabei eine ggf. exzentrische Drehbewegung des Bauelements erfasst wird. Dabei wird der Versatz des Bauelement-Mittelpunkts relativ zu der Rotationsachse der Haltevorrichtung erfasst. Die Rotationsachse kann insbesondere bei einer leichten Krümmung bzw. Verbiegung der Haltevorrichtung nicht genau mit der Symmetrieachse der Haltevorrichtung zusammen fallen. Der erfasste Versatz wird mit einer sog. Verpackungstoleranz verglichen, welche ein Maß für mögliche Toleranzen beim Abholprozess des Bauelements ist. Die Verpackungstoleranz wird insbesondere von der Größe von sog. Bauelement-Taschen bestimmt, in denen die zuzuführenden Bauelemente beispielsweise in einem Bauelementegurt einzeln verpackt sind.

Um die Ausschussrate an aufgrund eines zu großen Versatzes zu verwerfenden Bauelementen zu reduzieren, ist es bekannt, einen Lernalgorithmus zu verwenden. Damit kann die optimale Abholposition der Haltevorrichtung oberhalb einer Bauelement-Tasche anhand der Position von bereits abgeholten und vermessenen Bauelementen ermittelt werden. Dabei wird voraus gesetzt, dass sich das Bauelement innerhalb der Verpackungstoleranz befindet. Mit jedem erfolgreichen Abholversuch und dem Ergebnis der Positions- bzw. Versatzmessung wird die Abholposition der Haltevorrichtung für das nächste Bauelement verbessert. Auf diese Weise beträgt der Versatz des Bauelements bereits nach wenigen Abholvorgängen nur noch einen Bruchteil der Verpackungstoleranz.

Um bei sehr kleinen Bauelementen, welche in geringen Abständen voneinander auf einen Bauelementeträger platziert werden sollen, eine hohe Prozesssicherheit zu gewährleisten, könnte man die o. g. Verpackungstoleranz entsprechend absenken. Dann werden vom Vision System nur Bauelemente erkannt bzw. als gut klassifiziert, die lediglich einen sehr kleinen Versatz aufweisen, mit dem der notwendige minimale Abstand zwischen den Bauelementen auf dem Bauelementeträger sichergestellt werden kann. In diesem Fall ist jedoch der Lernprozess bezüglich der Abholposition in der Regel nicht möglich, da für die ersten Bauelemente keine exakten Abholpositionen bekannt sind. Somit wird in der Regel eine nicht mittige Bauelement-Abholung mit einem großen Versatz erfolgen und die aufgenommenen Bauelemente werden vom Vision System als zu verwerfende Bauelemente klassifiziert.

Der Erfindung liegt die Aufgabe zugrunde, ein Verfahren zum Klassifizieren des Versatzes von mittels einer Haltevorrichtung aufgenommenen Bauelementen zu schaffen, welches auch für kleine Bauelemente sowohl eine hohe Prozesssicherheit als auch einen effektiven Lernprozess bezüglich der Abholpositionen von nachfolgenden Bauelementen ermöglicht.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird ein Verfahren zum Klassifizieren eines von einer Haltevorrichtung aufgenommenen elektronischen Bauelements beschrieben, welches insbesondere zum Zwecke einer fehlerfreien Bestückung eines Bauelementeträgers mit Bauelementen durchgeführt werden kann. Das erfindungsgemäße Verfahren weist folgende Schritte auf:
(a) Aufnehmen des Bauelements von einer Abholposition einer Bauelement-Zuführeinrichtung mittels einer Haltevorrichtung,
(b) Erfassen des aufgenommenen Bauelements mittels einer Sensorvorrichtung, (c) Ermitteln eines Versatzes zwischen dem Bauelement und der Haltevorrichtung mittels einer der Sensorvorrichtung nachgeschalteten Auswerteeinheit, (d) Vergleichen des Versatzes mit einem ersten Referenzwert und mit einem zweiten Referenzwert, und (e) Klassifizieren des aufgenommenen Bauelements. Bei der Klassifizierung wird, wenn der ermittelte Versatz kleiner ist als der erste Referenzwert und größer ist als der zweite Referenzwert, das aufgenommene Bauelement als ein zu verwerfendes Bauelement klassifiziert. Ferner wird der ermittelte Versatz für einen Lernprozess bezüglich der zu erwartenden Abholpositionen von zukünftigen Bauelementen verwendet.

Dem genannten Verfahren liegt die Erkenntnis zugrunde, dass auch Bauelemente, die aufgrund von hohen Anforderungen bezüglich des Versatzes zwischen Bauelement und Haltevorrichtung nicht für eine zuverlässige Bestückung verwendet werden können und demzufolge von dem Bestückprozess entfernt werden müssen, für einen Lernvorgang bzgl. von zu erwartenden Abholpositionen für nachfolgende Bauelemente verwendet werden können. Auf diese Weise kann die Dauer des Lernprozesses erheblich verkürzt werden, so dass im Vergleich zu bekannten Lernverfahren für eine möglichst mittige Bauelement-Abholung deutlich weniger Bauelemente verworfen werden müssen.

Unter dem Begriff Versatz kann in diesem Zusammenhang ein Abstand des aufgenommenen Bauelements, insbesondere eines Referenzpunktes oder einer Referenzachse des aufgenommenen Bauelements, zu einer Sollposition des Bauelements an der Haltevorrichtung verstanden werden. Weiterhin kann der Versatz ein Abstand des aufgenommenen Bauelements, insbesondere eines Referenzpunktes oder einer Referenzachse des aufgenommenen Bauelements, zum Halteelement, insbesondere zu einem Referenzpunkt oder einer Referenzachse des Halteelements, sein. Insbesondere kann unter dem Begriff Versatz in diesem Zusammenhang ein Abstand zwischen der Bauelementmitte und der Spitze der Haltevorrichtung verstanden werden, an der das Bauelement aufgenommen wird. Die Spitze der Haltevorrichtung kann dabei bevorzugt durch die Symmetrieachse der Haltevorrichtung bezüglich der Außenkontur der Haltevorrichtung definiert sein. Im Falle einer Krümmung der Haltevorrichtung kann zum Beispiel weiterhin die Außenkontur an dem einem aufgenommenen Bauelement zugewandten Ende der Haltevorrichtung maßgeblich sein.

Bei bereits bestückten Bauelementen kann die Haltevorrichtung nicht an beliebigen Stellen des Bauelementeträgers abgesenkt werden ohne ggf. bereits bestückte Bauelemente zu beschädigen oder zu verschieben. Somit hängt die Fähigkeit eines Bestückautomaten ein Bauelement nahe neben ein bereits bestücktes Bauelement aufzusetzen, unmittelbar mit dem Versatz zwischen der Bauelementmitte und der Spitze der Haltevorrichtung zusammen.

Es wird ausdrücklich darauf hingewiesen, dass unter dem Begriff Versatz nicht der Abstand zwischen der Bauelementmitte und der Rotationsachse der Haltevorrichtung zu verstehen ist. Unter der Voraussetzung einer mittigen Bauelementaufnahme könnte ein derartiger Versatz nämlich durch eine entsprechende Positionierung der Haltevorrichtung parallel zu der Oberfläche des Bauelementeträgers kompensiert werden.

Selbstverständlich erfordert eine Bestimmung des Versatzes zwei getrennte Positionserfassungen. Mittels eines ersten bevorzugt optischen Messvorgangs wird die Position der Spitze der Haltevorrichtung gemessen. Mittels eines zweiten Messvorgangs wird die Position eines aufgenommenen Bauelements gemessen. Der Versatz ergibt sich dann aus einer Differenzbildung zwischen den beiden gemessenen Positionen.

In diesem Zusammenhang wird darauf hingewiesen, dass es für eine zuverlässige Bestimmung des Versatzes nicht unbedingt erforderlich ist, jeweils beide Positionen zu bestimmen. So kann beispielsweise die Position einer bestimmten Haltevorrichtung einmalig insbesondere beim Start eines Bestückprogramms oder möglichst unmittelbar nach einem Wechsel der Haltevorrichtung erfasst werden. Diese Position kann dann für nachfolgende Versatzbestimmungen von unterschiedlichen Bauelementen verwendet werden, welche von dieser Haltevorrichtung aufgenommenen wurden.

Um die oben genannte Klassifizierungsbedingung zu erfüllen ist selbstverständlich der erste Referenzwert größer als der zweite Referenzwert. In diesem Zusammenhang wird darauf hingewiesen, dass der Versatz lediglich dem Betrag nach ermittelt wird und dass die Richtung des Versatzes nicht berücksichtigt wird. Demzufolge ist sowohl der erste als auch der zweite Referenzwert eine positive Größe.

Gemäß Anspruch 2 wird eine zweite Klassifizierungsbedingung bzgl. des Versatzes des aufgenommenen Bauelements angegeben. Demnach wird, wenn der Versatz kleiner ist als der zweite Referenzwert, das Bauelement als ein zu bestückendes Bauelement klassifiziert und der ermittelte Versatz für den Lernprozess bezüglich der zu erwartenden Abholpositionen von zukünftigen Bauelementen verwendet. Dieser Fall wird insbesondere dann häufig vorkommen, wenn der Lernprozess bereits so weit fortgeschritten ist, dass die meisten Bauelemente mit lediglich einem geringen Versatz von der Haltevorrichtung aufgenommen werden.

Gemäß Anspruch 3 wird eine dritte Klassifizierungsbedingung bzgl. des Versatzes des aufgenommenen Bauelements angegeben. Demnach wird, wenn der Versatz größer ist als der erste Referenzwert, das Bauelement als ein zu verwerfendes Bauelement klassifiziert.

In diesem Zusammenhang wird darauf hingewiesen, dass der Versatz auch so groß sein kann, dass sich bei einer vermeintlichen Bauelement-Erfassung das aufgenommene Bauelement auch außerhalb eines vorgegebenen Erfassungsbereich der Sensorvorrichtung befindet und somit nicht oder nur teilweise erfasst wird. In diesem Fall wird davon ausgegangen, dass der Versatz auf jeden Fall größer ist als der erste Referenzwert.

Gemäß Anspruch 4 ist die Sensorvorrichtung eine optische Sensorvorrichtung. Insbesondere ist die Sensorvorrichtung eine Kamera, die beispielsweise einen CCD-Sensorchip aufweist. Die Kamera kann analoge oder bevorzugt digitale Bilddaten liefern, die mittels einer geeigneten Signalleitung an die Auswerteeinheit übergeben werden.

Es wird jedoch darauf hingewiesen, dass die Sensorvorrichtung auch taktile Sensoren, kapazitive Sensoren, induktive Sensoren und/oder Ultraschall-Sensoren aufweisen kann.

Gemäß Anspruch 5 wird der erste Referenzwert abhängig von der Genauigkeit gewählt, mit der das Bauelement an der Abholposition bereitgestellt wird. Dabei ist der erste Referenzwert insbesondere von der Verpackung des Bauelements während der Bauelement-Zuführung und von der Stabilität der Bauelement-Zuführung durch eine entsprechende Bauelement-Zuführeinrichtung abhängig.

Typischerweise sind die zugeführten Bauelemente einzeln in sog. Bauelementtaschen eines Bauelementgurtes aufbewahrt. Die Größen der Bauelementtaschen sind damit in besonderem Maße für den ersten Referenzwert maßgeblich. Der erste Referenzwert kann demzufolge als Verpackungstoleranz bezeichnet werden.

Gemäß Anspruch 6 wird der zweite Referenzwert abhängig von den Abständen zwischen benachbarten Bauelement-Einbauplätzen eines zu bestückenden Bauelementeträgers gewählt. Um eine Kollision zwischen der Haltevorrichtung und bereits auf dem Bauelementeträger aufgesetzten Bauelementen zu verhindern, wird der zweite Referenzwert so gewählt, dass für eine Verarbeitung des aufgenommenen Bauelements der Versatz zwischen Haltevorrichtung und aufgenommenen Bauelement kleiner sein muss als der Abstand zwischen einem bereits bestückten Bauelement und dem für das aufgenommene Bauelement vorgesehenen Einbauplatz auf dem Bauelementeträger. Der zweite Referenzwert kann somit auch als Versatztoleranz bezeichnet werden.

Um eine zuverlässige, d.h. fehlerfreie Bestückung und zugleich einen geringen Ausschuss an zu verwerfenden Bauelementen zu gewährleisten, wird für den zweiten Referenzwert bzw. für die Versatztoleranz ein Wert gewählt, der umso kleiner ist, je geringer die Beabstandung der vorgesehenen oder bereits verwendeten Bauelement-Einbauplätze ist. Der zweite Referenzwert ist demzufolge eine Kenngröße des zu bestückenden Bauelementeträgers bzw. der räumlichen Verteilung der auf dem Bauelementeträger angeordneten Bauelement-Einbaupositionen.

Es wird darauf hingewiesen, dass die Bestückgenauigkeit des verwendeten Bestückautomaten stets eine gewisse Unschärfe bzgl. der Position eines bereits bestückten Bauelements verursacht. Diese Unschärfe ist selbstverständlich bei der Wahl der zweiten Referenzwertes zu berücksichtigen, um zuverlässig eine kollisionsfreie Bauelement-Bestückung zu gewährleisten. Für den zweiten Referenzwert muss dabei ein umso kleinerer Wert gewählt werden, je größer die Bestückgenauigkeit des bereits bestückten Bauelements ist.

Die Bestückgenauigkeit kann jedoch dadurch eliminiert werden, dass eine separate Positionsvermessung des bestückten Bauelements durchgeführt wird. In diesem Fall ist dann lediglich die entsprechende Messgenauigkeit bei der Wahl des zweiten Referenzwertes zu berücksichtigen.

Gemäß Anspruch 7 wird der zweite Referenzwert abhängig von der für das aufgenommene Bauelement jeweils vorgesehenen Bestückposition auf dem Bauelementeträger gewählt. Dies bedeutet das der zweite Referenzwert nicht nur eine Kenngröße des zu bestückenden Bauelementeträgers sondern eine Kenngröße für eine individuelle Bestückposition auf dem Bauelementeträger ist.

Durch eine derartige dynamische Anpassung des zweiten Referenzwertes an die Beabstandung der vorgesehenen individuellen Einbauposition des aufgenommenen Bauelements können Bauelementeträger mit einer besonders niedrigen Ausschussrate von Bauelementen bestückt werden. Der zweite Referenzwert bzw. die Versatztoleranz wird demzufolge lediglich so klein gewählt, wie dies für eine zuverlässige Bestückung des jeweiligen Bauelements unbedingt erforderlich ist.

Gemäß Anspruch 8 wird abhängig von dem gemessenen Versatz für das aufgenommene Bauelement eine geeignete Bestückposition auf dem Bauelementeträger ausgewählt. Dies bedeutet, dass insbesondere bei der Bestückung von Leiterplatten mit mehreren gleichartigen Bauelementen das Bestückprogramm abhängig von dem jeweils gemessenen Versatz dynamisch angepasst wird.

Dabei wird für das jeweils aufgenommene Bauelement ein Einbauplatz ausgewählt, welcher trotz eines zuvor ermittelten Versatzes eine zuverlässige und fehlerfreie Bestückung erlaubt. Demzufolge kann ein mit einem vergleichsweise großen Versatz aufgenommenes Bauelement anstelle einer Verwerfung an bestimmten Einbaupositionen bestückt werden, die zwar gemäß dem vorgesehen Bestückprogramm zunächst noch nicht besetzt werden sollten, die aber infolge einer vergleichsweise großen Beabstandung zu benachbarten Bauelementen eine fehlerfreie Bestückung auch von mit großem Versatz aufgenommenen Bauelementen erlauben. Durch eine derartige dynamische Anpassung des Bestückprogramms kann die Ausschussrate an elektronischen Bauelementen auf vorteilhafte Weise weiter reduziert werden.

Gemäß Anspruch 9 ist die Haltevorrichtung ein Sauggreifer. Dies hat den Vorteil, dass sich das genannte Verfahren auch für sog. Saugpipetten eignet, welche üblicherweise für die Bestückung von Bauelementen mit kleiner Baugröße verwendet werden.

Es wird darauf hingewiesen, dass bei kleinen Gehäuseformen für Bauelemente wie beispielsweise die sog. Gehäuseform 0201 mit einer Querschnittsfläche von 0,6 mm x 0,3 mm oder die Gehäuseform 01005 mit einer Auflagefläche von lediglich 0,4 mm x 0,2 mm die Spitzen der verwendeten Pipetten typischerweise eine ähnlich große Querschnittsfläche wie das Bauelement selbst aufweisen. Derartig kleine Bauelemente werden in Anbetracht der zunehmenden Miniaturisierung von elektronischen Bauelementen und Baugruppen in Zukunft jedoch immer häufiger verwendet. Somit wird die Bedeutung einer präzisen und zuverlässigen Bestückung von kleinen Bauelementen in unmittelbarer Nähe von bereits bestückten Bauelementen für den Aufbau von kompakten elektronischen Baugruppen in Zukunft immer größer werden.

Gemäß Anspruch 10 wird zum Ermitteln des Versatzes zwischen dem Bauelement und dem Sauggreifer die dem Bauelement zugewandte Spitze des Sauggreifers verwendet. Dabei wird die räumliche Lage der Spitze anhand der Symmetrieachse der Außenkontur des Sauggreifers bestimmt. Dies hat den Vorteil, dass die räumliche Lage der Mitte der Sauggreifer- bzw. Pipettenspitze besonders genau ermittelt werden kann.

Abhängig von den Größenverhältnissen zwischen Bauelement und Sauggreiferspitze kann die Außenkontur der Sauggreiferspitze selbst oder die Außenkontur des Saugreifers an einem von der Sauggreiferspitze beabstandeten Außenumfang des Sauggreifers verwendet werden. Da Saugpipetten typischerweise eine zumindest teilweise konische Form aufweisen, kann auch der Versatz zwischen Bauelement und Sauggreifer auch dann zuverlässig bestimmt werden, wenn das Bauelement größer ist als die Spitze des Sauggreifers.

Mit dem unabhängigen Patentanspruch 11 wird eine Bestückvorrichtung zum automatischen Bestücken von Bauelementeträgern mit Bauelementen geschaffen. Die Bestückvorrichtung weist einen Prozessor auf, der derart eingerichtet ist, dass das oben genannte Verfahren zum Klassifizieren eines von einer Haltevorrichtung aufgenommenen Bauelements durchgeführt werden kann.

Mit dem unabhängigen Patentanspruch 12 wird ein computerlesbares Speichermedium geschaffen, in welchem ein Bearbeitungsprogramm für einen Bestückautomaten zum Bestücken von Bauelementeträgern mit Bauelementen gespeichert ist. Wenn das Programm von einem Prozessor ausgeführt wird, kann das oben beschriebene Verfahren zum Klassifizieren eines von einer Haltevorrichtung aufgenommenen elektronischen Bauelements durchgeführt werden.

Mit dem unabhängigen Patentanspruch 13 wird ein Programm-Element zum Bestücken von Bauelementeträgern mit Bauelementen beschrieben. Wenn das Programm-Element von einem Prozessor ausgeführt wird, kann das oben beschriebene Verfahren zum Klassifizieren eines von einer Haltevorrichtung aufgenommenen elektronischen Bauelements durchgeführt werden.

Das Programm-Element kann als computerlesbarer Anweisungscode in jeder geeigneten Programmiersprache wie beispielsweise in JAVA, C++ etc. implementiert sein. Das Programm-Element kann auf einem computerlesbaren Speichermedium (CD-Rom, DVD, Wechsellaufwerk, flüchtiger oder nicht-flüchtiger Speicher, eingebauter Speicher/Prozessor etc.) abgespeichert sein. Der Anweisungscode kann einen Computer oder andere programmierbare Geräte derart programmieren, dass die gewünschten Funktionen ausgeführt werden. Ferner kann das Programm-Element in einem Netzwerk wie beispielsweise dem Internet bereitgestellt werden, von dem es bei Bedarf von einem Nutzer herunter geladen werden kann.

Die Erfindung kann sowohl mittels eines Computerprogramms, d.h. einer Software, als auch mittels einer oder mehrerer spezieller elektrischer Schaltungen, d.h. in Hardware oder in beliebig hybrider Form, d.h. mittels Software-Komponenten und Hardware-Komponenten, realisiert werden.

Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellungen
- Figur 1: eine perspektivische Darstellung einer Bestückvorrichtung zur Durchführung des Verfahrens zum Klassifizieren eines von einer Haltevorrichtung aufgenommenen elektronischen Bauelements,
- Figur 2a: eine ideale mittige Aufnahme eines Bauelements mittels einer Saugpipette,
- Figur 2b: eine reale exzentrische Aufnahme eines Bauelements mittels einer Saugpipette, und
- Figur 3: eine reale Ist-Anordnung von auf einem Bauelementeträger nebeneinander bestückten Bauelementen im Vergleich zu der entsprechenden idealen Soll-Anordnung der Bauelemente.

An dieser Stelle bleibt anzumerken, dass sich in der Zeichnung die Bezugszeichen von gleichen oder von einander entsprechenden Komponenten lediglich in ihrer ersten Ziffer unterscheiden.

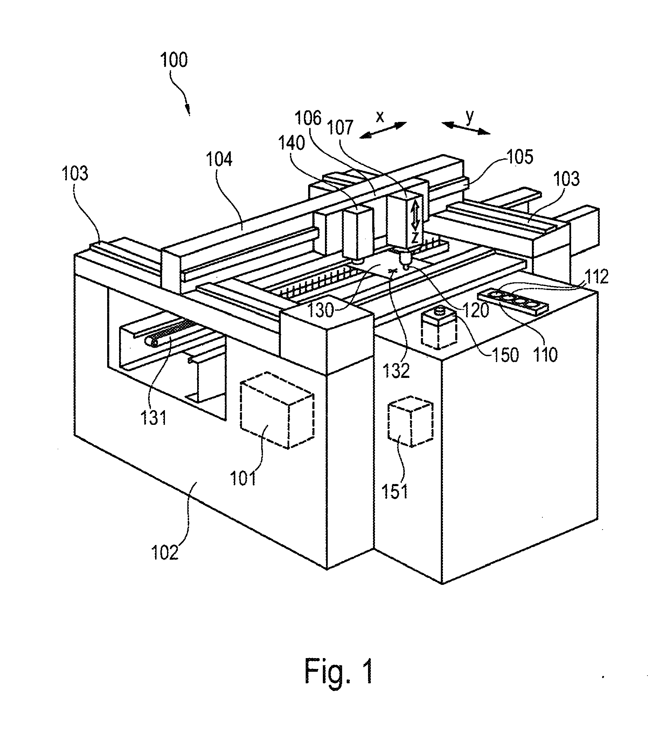

Figur 1 zeigt einen Bestückautomaten 100, welcher einen Rahmen 102 aufweist, an dem zwei parallel ausgerichtete Führungen 103 angebracht sind. Die beiden Führungen 103 tragen einen quer stehenden Trägerarm 104. Der quer stehende Trägerarm 104 weist selbst eine Führung 105 aufweist, an welchem ein Trägerelement 106 verschiebbar gelagert ist. Die beiden Führungen 103 verlaufen entlang einer y-Richtung, die Führung 105 verläuft entlang einer x-Richtung. An dem Trägerelement 106 ist ein Bestückkopf 107 angeordnet, welcher zumindest eine als Saugpipette 120 ausgebildete Haltevorrichtung aufweist, die mittels eines nicht dargestellten Antriebs entlang einer zu der x- und zu der y-Richtung senkrechten z-Richtung verschiebbar ist.

Um die Winkellage von aufgenommenen Bauelemente zu korrigieren und um somit die Bauelemente korrekt bestücken zu können, ist ferner ein nicht dargestellter Drehantrieb. Mittels des Drehantriebs kann die Saugpipette 120 um ihre Längsachse gedreht werden.

Der Bestückautomat 100 weist ferner eine Bauelement-Zuführeinrichtung 112 auf, über welche in Figur 1 nicht dargestellte Bauelemente dem Bestückprozess zugeführt werden können. Ferner umfasst der Bestückautomat 100 ein Förderband 131, mit dem eine Leiterplatte 130 in den Bestückbereich eingebracht werden kann. Die Saugpipette 107 kann durch eine entsprechende Bewegung des Bestückkopfes 107 innerhalb der x-y-Ebene innerhalb des gesamten Bestückbereichs positioniert werden.

Der Bestückautomat 100 weist außerdem einen Prozessor bzw. eine Steuereinheit 101 auf. Auf der Steuereinheit 101 kann ein Bearbeitungsprogramm für den Bestückautomaten 100 zum Bestücken von Bauelementeträgern mit Bauelementen ausgeführt werden, so dass alle Komponenten des Bestückautomaten 100 in synchronisierter Weise arbeiten und somit zu einem fehlerfreien und zügigem Bestücken von Bauelementeträgern mit Bauelementen beitragen.

An dem Trägerelement 106 ist zusätzlich eine sog. Leiterplatten-Kamera 140 befestigt, welche zur Erfassung einer an der Leiterplatte 130 angebrachten Markierung 132 vorgesehen ist. Auf diese Weise kann die genaue Position der in dem Bestückbereich eingebrachten Leiterplatte 130 durch eine Lagevermessung der Markierung 132 innerhalb des Gesichtsfeldes der Leiterplattenkamera 140 bestimmt werden.

Zur Positionsvermessung und zur Kontrolle von aufgenommenen Bauelementen ist eine Kamera 150 vorgesehen, welche gemäß dem hier dargestellten Ausführungsbeispiel in einer festen Position an dem Bestückautomaten 100 angeordnet ist. Die optische Bauelement-Vermessung erfolgt bevorzugt unmittelbar nach der Aufnahme des Bauelements von der Bauelement-Zuführeinrichtung 110 durch eine entsprechende Positionierung des Bestückkopfes 107 oberhalb der Bauelementekamera 150. Das von der Kamera 150 aufgenommene Bild wird in einer Auswerteeinheit 151 ausgewertet und dabei der Versatz des von der Saugpipette 120 aufgenommenen Bauelements relativ zu der Saugpipette ermittelt.

Die Auswerteeinheit 151 kann auch in der den Bestückautomaten 100 steuernden Steuereinheit 101 integriert sein. Dabei kann die Auswerteeinheit 151 mittels einer eigenen Hardware oder auch mittels einer geeigneten Software realisiert sein.

Es wird darauf hingewiesen, dass die Erfindung keineswegs auf die Verwendung in dem hier dargestellten Bestückautomaten 100 beschränkt ist. Die Erfindung kann beispielsweise auch mit einer Bauelemente-Kamera realisiert werden, welche zusammen mit dem Bestückkopf verfahren wird und welche dafür vorgesehen ist, die aufgenommenen Bauelemente während des Transports von der Aufnahmeposition hin zu der Bestückposition zu vermessen.

Ebenso kann die Erfindung im Zusammenhang mit einem sog. Mehrfach-Bestückkopf eingesetzt werden, welcher mehrere Haltevorrichtungen aufweist und somit gleichzeitig mehrere Bauelemente transportieren kann. Dabei können die Haltevorrichtungen zeilen- bzw. matrixartig angeordnet sein. Ebenso können die Haltevorrichtungen jedoch auch um eine Rotationsachse radial abstehen abgeordnet sein, so dass durch eine Drehung der Haltevorrichtungen mehrere Bauelemente sequentiell aufgenommen und auch wieder abgesetzt werden können. Selbstverständlich kann die Erfindung jedoch auch mit beliebigen anderen Arten von Einfach- oder Mehrfach-Bestückköpfen realisiert werden.

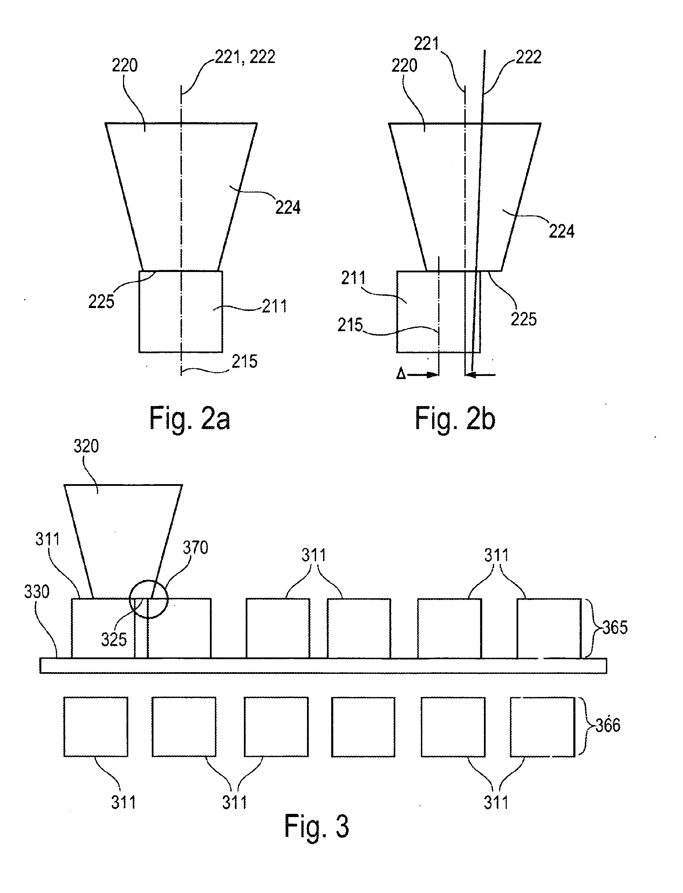

Figur 2a zeigt eine ideale mittige Aufnahme eines Bauelements 211 mittels einer Saugpipette 220. Die Symmetrieachse 221 der Saugpipette 220 und die Symmetrieachse 215 des Bauelements 211 fallen zusammen.

Die Saugpipette 220 weist keinerlei Unrundheit auf. Damit fällt die Rotationsachse 222 der Saugpipette 220 mit der Symmetrie- bzw. Mittelachse 221 der Saugpipette 220 zusammen.

Die Saugpipette 220 weist eine im wesentlichen konische Form auf, wobei sich der Querschnitt der Saugpipette 220 senkrecht zur Mittelachse 221 in Richtung zu einer Spitze 225 der Saugpipette 220 verjüngt. Bei einer Vermessung der Lage des aufgenommenen Bauelements 211 durch eine nicht dargestellte Kamera, welche bevorzugt unterhalb des aufgenommenen Bauelements angeordnet ist, kann somit auch dann ein möglicher Versatz zwischen Bauelement 211 und der Mittelachse 221 bestimmt werden, wenn der Querschnitt des Bauelement 211 gleich groß oder sogar größer ist als der Querschnitt der Pipettenspitze 225. In diesem Fall wird die Position des Bauelements 211 durch die relative Lage zwischen der Mitte des Bauelements 211 und einer Symmetrieachse der Außenkontur 224 der Saugpipette 220 bestimmt. Aufgrund der konischen Form der Saugpipette 220 ist die Außenkontur auch dann sichtbar, wenn das Bauelement 211 etwas größer bzw. breiter als die Pipettenspitze 225 ist.

Figur 2b zeigt eine reale exzentrische Aufnahme eines Bauelements 211 mittels einer Saugpipette 220. Die Saugpipette 220 weist eine leichte Deformation auf, so dass die Symmetrieachse 221 der Saugpipette 220 nicht mit der Rotationsachse 222 zusammenfällt. Um diese Rotationsachse 222 dreht sich die Saugpipette 220, wenn ein nicht dargestellter hohler Schaft, auf welchen die Saugpipette 220 aufgesteckt ist, um seine Längsachse gedreht wird.

Das nicht mittig aufgenommene Bauelement 211 weist somit relativ zu der Saugpipette 220 einen Versatz Δ auf, der sich aus dem Abstand zwischen der Symmetrieachse 215 des Bauelements 211 und der Symmetrieachse 221 der Saugpipette 220 ergibt. Dieser Versatz Δ wird mittels einer Kamera durch eine gemeinsame Erfassung des Bauelements 211 und der Außenkontur 224 der Saugpipette 220 ermittelt.

Der ermittelte Versatz Δ wird mit zwei Referenzwerten, einem ersten Referenzwert und einem zweiten Referenzwert verglichen.

Der erste Referenzwert wird gemäß dem hier beschriebenen Ausführungsbeispiel so gewählt, dass er ein Maß für mögliche Toleranzen beim Abholprozess des Bauelements 211 ist. In diesem Fall wird der erste Referenzwert insbesondere von der Größe von sog. Bauelement-Taschen bestimmt, in denen die zuzuführenden Bauelemente 211 beispielsweise in einem nicht dargestellten Bauelementegurt einzeln verpackt sind. Der erste Referenzwert kann somit auch als Verpackungstoleranz bezeichnet werden.

Der zweite Referenzwert wird gemäß dem hier beschriebenen Ausführungsbeispiel abhängig von den Abständen zwischen benachbarten Bauelement-Einbauplätzen eines zu bestückenden Bauelementeträgers gewählt. Dabei ist der zweite Referenzwert so klein, dass für eine Bestückung des aufgenommenen Bauelements 211 der Versatz zwischen der Saugpipette 220 und dem aufgenommen Bauelement 211 kleiner sein muss als der Abstand zwischen einem bereits bestückten Bauelement und dem für das aufgenommene Bauelement 211 vorgesehenen Einbauplatz. Auf diese Weise kann eine Kollision zwischen der Saugpipette 220 und bereits auf dem Bauelementeträger aufgesetzten Bauelementen zuverlässig verhindert werden. Der zweite Referenzwert kann somit auch als Versatztoleranz bezeichnet werden.

Um zum einen eine hohe Prozesssicherheit und zum anderen einen zügigen Lernvorgang zu gewährleisten, wird das von der Saugpipette 220 aufgenommene Bauelement 211 hinsichtlich seines Versatzes Δ in drei unterschiedliche Kategorien eingeteilt:
A) Der Versatz Δ ist größer als der erste Referenzwert:
   In diesem Fall wird das Bauelement 211 als ein zu verwerfendes Bauelement 211 klassifiziert und durch ein Abwerfen des Bauelements 211 an geeigneter Stelle von dem Bestückprozess entfernt.
B) Der Versatz Δ ist kleiner als der erste Referenzwert und größer als der zweite Referenzwert:
   In diesem Fall wird das aufgenommene Bauelement 211 ebenfalls als ein zu verwerfendes Bauelement 211 klassifiziert und von dem Bestückprozess entfernt. Der ermittelte Versatz Δ wird jedoch für einen Lernprozess bezüglich der zu erwartenden Abholpositionen von zukünftigen Bauelementen verwendet.
C) Der Versatz Δ ist kleiner als der zweite Referenzwert:
   In diesem Fall wird das Bauelement 211 als ein zu bestückendes Bauelement 211 klassifiziert. Außerdem wird der ermittelte Versatz A für den Lernprozess bezüglich der zu erwartenden Abholpositionen von zukünftigen Bauelementen verwendet.

Figur 3 zeigt eine Seitenansicht einer realen Ist-Anordnung 365 von nebeneinander bestückten Bauelementen 311, die durch eine sequentielle Bestückung mittels zumindest einer Saugpipette 320 auf einen Bauelementeträger 330 aufgesetzt wurden. Die schematisch und nicht maßstabsgetreu dargestellten Bauelemente 311 weisen die o. g. Gehäuseform 01005 auf und sind mit einem Sollabstand von 100µm nebeneinander bestückt.

Aufgrund einer Bestückgenauigkeit von 50µm sind die realen Positionen 365 der bestückten Bauelemente 311 jedoch um ihre äquidistanten Sollpositionen 360 statistisch verteilt. Dies kann dazu führen, dass bei der Bestückung des links dargestellten Bauelements 311, welches mit einem vergleichsweise großen Versatz von der Saugpipette 320 aufgenommen ist, ein seitlich überstehender Teil der Pipettenspitze 325 das unmittelbar benachbarte und bereits bestückte Bauelement 311 innerhalb eines Kollisionsbereichs berührt. Diese Berührung kann insbesondere dazu führen, dass dieses Bauelement verschoben wird, so dass es bei einem der Bestückung nachfolgendem Lötvorgang nicht richtig mit den auf der Leiterplatte 330 vorgesehenen Anschlussflächen kontaktiert wird.

Gemäß dem hier dargestellten Ausführungsbeispiel wird eine derartige Kollision dadurch verhindert, dass das Bauelement nur dann bestückt wird, wenn der Versatz Δ kleiner als die Versatztoleranz ist.

Es wird darauf hingewiesen, dass die hier beschriebenen Ausführungsformen lediglich ein beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

## Patentansprüche

1. Verfahren zum Klassifizieren eines von einer Haltevorrichtung (120, 220) aufgenommenen elektronischen Bauelements (211), insbesondere zum Zwecke einer fehlerfreien Bestückung eines Bauelementeträgers (130, 330) mit dem Bauelement (211, 311), das Verfahren aufweisend folgende Schritte:
• Aufnehmen des Bauelements (211) von einer Abholposition (112) einer Bauelement-Zuführeinrichtung (110) mittels einer Haltevorrichtung (120, 220, 320),
• Erfassen des aufgenommenen Bauelements (211) mittels einer Sensorvorrichtung (150),
• Ermitteln eines Versatzes (Δ) zwischen dem aufgenommenen Bauelement (211) und der Haltevorrichtung (120, 220) mittels einer der Sensorvorrichtung (150) nachgeschalteten Auswerteeinheit (151),
• Vergleichen des Versatzes (Δ) mit einem ersten Referenzwert und mit einem zweiten Referenzwert, und
• Klassifizieren des aufgenommenen Bauelements (211), wobei, wenn der Versatz (Δ) kleiner ist als der erste Referenzwert und größer ist als der zweite Referenzwert,
- das aufgenommene Bauelement (211) als ein zu verwerfendes Bauelement (211) klassifiziert wird und
- der ermittelte Versatz (Δ) für einen Lernprozess bezüglich der zu erwartenden Abholpositionen von zukünftigen Bauelementen verwendet wird.

2. Verfahren nach Anspruch 1, wobei
das Klassifizieren des aufgenommenen Bauelements (211) ferner aufweist, dass,
wenn der Versatz (Δ) kleiner ist als der zweite Referenzwert,
- das aufgenommene Bauelement (211) als ein zu bestückendes Bauelement (211) klassifiziert wird und
- der ermittelte Versatz (Δ) für den Lernprozess bezüglich der zu erwartenden Abholpositionen von zukünftigen Bauelementen verwendet wird.

3. Verfahren nach einem der Ansprüche 1 bis 2, wobei das Klassifizieren des aufgenommenen Bauelements (211) ferner aufweist, dass,
wenn der Versatz (Δ) größer ist als der erste Referenzwert,
- das aufgenommene Bauelement (211) als ein zu verwerfendes Bauelement (211) klassifiziert wird.

4. Verfahren nach einem der Ansprüche 1 bis 3, wobei
die Sensorvorrichtung eine optische Sensorvorrichtung (150), insbesondere eine Kamera (150) ist.

5. Verfahren nach einem der Ansprüche 1 bis 4, wobei
der erste Referenzwert abhängig von der Genauigkeit gewählt wird, mit der das Bauelement (211) an der Abholposition (112) bereitgestellt wird.

6. Verfahren nach einem der Ansprüche 1 bis 5, wobei
der zweite Referenzwert abhängig von den Abständen zwischen benachbarten Bauelement-Einbauplätzen eines zu bestückenden Bauelementeträgers (130, 330) gewählt wird.

7. Verfahren nach einem der Ansprüche 1 bis 6, wobei
der zweite Referenzwert abhängig von der für das aufgenommene Bauelement (211) jeweils vorgesehenen Bestückposition auf dem Bauelementeträger (130, 330) gewählt wird.

8. Verfahren nach einem der Ansprüche 1 bis 7, wobei
abhängig von dem gemessenen Versatz für das aufgenommene Bauelement (211) eine geeignete Bestückposition auf dem Bauelementeträger (130, 330) ausgewählt wird.

9. Verfahren nach einem der Ansprüche 1 bis 8, wobei
die Haltevorrichtung ein Sauggreifer (120, 220, 320) ist.

10. Verfahren nach Anspruch 9, wobei
zum Ermitteln des Versatzes (Δ) zwischen dem aufgenommenen Bauelement (211) und dem Sauggreifer (220) eine dem Bauelement (211) zugewandte Spitze (225) des Sauggreifers (220) verwendet wird, wobei die räumliche Lage der Spitze (225) anhand der Außenkontur (224) des Sauggreifers (220) bestimmt wird.

11. Bestückvorrichtung zum automatischen Bestücken von Bauelementeträgern (130, 330) mit Bauelementen (211, 311), aufweisend
einen Prozessor (101), der derart eingerichtet ist, dass das Verfahren nach einem der Ansprüche 1 bis 10 durchführbar ist.

12. Computerlesbares Speichermedium, in dem ein Programm zum Klassifizieren eines von einer Haltevorrichtung (120, 220) aufgenommenen elektronischen Bauelements (211) gespeichert ist, welches Programm,
wenn es von einem Prozessor (101) ausgeführt wird, zum Durchführen des Verfahrens nach einem der Ansprüche 1 bis 10 eingerichtet ist.

13. Programm-Element
zum Klassifizieren eines von einer Haltevorrichtung (120, 220) aufgenommenen elektronischen Bauelements (211), welches Programm-Element,
wenn es von einem Prozessor (101) ausgeführt wird, zum Durchführen des Verfahrens nach einem der Ansprüche 1 bis 10 eingerichtet ist.

## Claims

1. Method for classifying an electronic component (211) picked up by a retaining jig (120, 220), especially for the purposes of error-free placement of the component (211, 311) on a component carrier (130, 330), with the method having the following steps:
• Picking up the component (211) from a fetch position (112) of a component feed device (110) by means of a retaining jig (120, 220, 320),
• Detection of the component (211) picked up by means of a sensor facility (150),
• Determination of an offset (Δ) between the picked up component (211) and the retaining jig (120, 220) by means of an evaluation unit (151) connected downstream from the sensor facility (150),
• Comparison of the offset (Δ) with a first reference value and with a second reference value, and
• Classification of the component (211) picked up, whereby, when the offset (Δ) is less than the first reference value and greater than the second reference value,
- the component (211) picked up is classified as a component (211) to be discarded and
- the offset (Δ) determined is used for a learning process relating to the expected fetch positions of future components.

2. Method according to claim 1, with
another feature of the classification of the component (211) picked up being that
when the offset (Δ) is less than the second reference value,
- the component (211) picked up is classified as a component (211) to be placed.
- the offset (Δ) determined is used for the learning process relating to the expected fetch position of future components.

3. Method according to one of claims 1 to 2, with the classification of the picked-up component (211) having the further feature that
when the offset (Δ) is greater than the first reference value,
- the picked-up component (211) is classified as a component (211) to be discarded.

4. Method according to one of claims 1 to 3, with the sensor facility being an optical sensor facility (150), especially a camera (150).

5. Method according to one of claims 1 to 4, with the first reference value being selected as a function of the accuracy with which the component (211) is provided at the fetch position (112).

6. Method according to one of claims 1 to 5, with the second reference value being selected as a function of the distances between adjacent component mounting locations of a component carrier (130, 330) on which the components are to be placed.

7. Method according to one of claims 1 to 6, with the second reference value being selected as a function of the placement position on the component carrier (130, 330) provided in each case for the picked-up component (211).

8. Method according to one of claims 1 to 7, with a suitable position on the component carrier (130, 330) being selected as a function of the measured offset for the picked-up component (211).

9. Method according to one of claims 1 to 8, with the retaining jig being a vacuum gripper (120, 220, 320).

10. Method according to claim 9, whereby to determine the offset (Δ) between the picked-up component (211) and the vacuum gripper (220) a tip (225) of the vacuum gripper (220) facing towards the component (211) is used, with the spatial position of the tip (225) being determined on the basis of the external contour (224) of the vacuum gripper (220).

11. Pick-and-place device for automatic placement of components (211, 311) on component carriers (130, 330), having a processor (101) that is configured such that the method is able to be carried out according to one of claims 1 to 10.

12. Computer-readable storage medium in which a program for classifying an electronic component (211) picked up by a retaining jig (120, 220) is stored, which program,
when it is executed by a processor (101), is configured to carry out the method according to one of claims 1 to 10.

13. Program element
for classifying an electronic component (221) picked up by a retaining jig (120, 220), which program element,
when it is executed by a processor (101), is configured to carry out the method according to one of claims 1 to 10.

## Revendications

1. Procédé de classification d'un composant électronique (211) pris par un dispositif de retenue (120, 220), en particulier pour poser le composant (211, 311) sans erreur sur un support de composants (130, 330), le procédé comportant les étapes suivantes :
• prise du composant (211) d'une position d'enlèvement (112) d'un dispositif d'amenée de composants (110) au moyen d'un dispositif de retenue (120, 220, 320),
• détection du composant pris (211) au moyen d'un dispositif de détection (150),
• détermination d'un décalage (Δ) entre le composant pris (211) et le dispositif de retenue (120, 220) au moyen d'une unité d'évaluation (151) montée en aval du dispositif de détection (150),
• comparaison du décalage (Δ) avec une première valeur de référence et avec une deuxième valeur de référence et
• classification du composant pris (211),
- le composant pris (211) étant classé comme composant (211) à rejeter et
- le décalage (Δ) qui a été déterminé étant utilisé pour un processus d'apprentissage concernant les positions d'enlèvement escomptées de composants à venir
si le décalage (Δ) est inférieur à la première valeur de référence et supérieur à la deuxième valeur de référence.

2. Procédé selon la revendication 1, la classification du composant pris (211) étant en outre telle que, si le décalage (Δ) est inférieur à la deuxième valeur de référence,
- le composant pris (211) est classé comme composant (211) à poser et
- le décalage (Δ) qui a été déterminé est utilisé pour le processus d'apprentissage concernant les positions d'enlèvement escomptées de composants à venir.

3. Procédé selon l'une des revendications 1 à 2, la classification du composant pris (211) étant en outre telle que, si le décalage (Δ) est supérieur à la première valeur de référence, le composant pris (211) est classé comme composant (211) à rejeter.

4. Procédé selon l'une des revendications 1 à 3, le dispositif de détection étant un dispositif de détection optique (150), et plus particulièrement une caméra (150).

5. Procédé selon l'une des revendications 1 à 4, la première valeur de référence étant choisie en fonction de la précision avec laquelle le composant (211) est mis à disposition à la position d'enlèvement (112).

6. Procédé selon l'une des revendications 1 à 5, la deuxième valeur de référence étant choisie en fonction des distances entre des emplacements de composants voisins d'un support de composants à équiper (130, 330).

7. Procédé selon l'une des revendications 1 à 6, la deuxième valeur de référence étant choisie en fonction de la position de pose respectivement prévue pour le composant pris (211) sur le support de composants (130, 330).

8. Procédé selon l'une des revendications 1 à 7, une position de pose appropriée sur le support de composants (130, 330) étant sélectionnée pour le composant pris (211) en fonction du décalage mesuré.

9. Procédé selon l'une des revendications 1 à 8, le dispositif de retenue étant un préhenseur à ventouse (120, 220, 320).

10. Procédé selon la revendication 9, une pointe (225) du préhenseur à ventouse (220) tournée vers le composant (211) étant utilisée pour déterminer le décalage (Δ) entre le composant pris (211) et le préhenseur à ventouse (220), la position spatiale de la pointe (225) étant déterminée à l'aide du contour extérieur (224) du préhenseur à ventouse (220).

11. Dispositif de pose pour la pose automatique de composants (211, 311) sur des supports de composants (130, 330), comportant un processeur (101) qui est aménagé de manière telle que le procédé selon l'une des revendications 1 à 10 peut être exécuté.

12. Support de mémoire lisible par ordinateur, dans lequel est stocké un programme pour la classification d'un composant électronique (211) pris par un dispositif de retenue (120, 220), lequel programme, lorsqu'il est exécuté par un processeur (101), est aménagé pour exécuter le procédé selon l'une des revendications 1 à 10.

13. Élément de programme pour la classification d'un composant électronique (211) pris par un dispositif de retenue (120, 220), lequel élément de programme, lorsqu'il est exécuté par un processeur (101), est aménagé aux fins de l'exécution du procédé selon l'une des revendications 1 à 10.
